(19) **Europäisches Patentamt / European Patent Office / Office européen des brevets**

(11) **EP 1 429 378 B1**

(12) **EUROPEAN PATENT SPECIFICATION**

(45) Date of publication and mention of the grant of the patent:
**29.02.2012 Bulletin 2012/09**

(21) Application number: **02747725.6**

(22) Date of filing: **23.07.2002**

(51) Int Cl.:
**H01L 21/683** (2006.01)    **C09J 7/02** (2006.01)

(86) International application number:
**PCT/JP2002/007442**

(87) International publication number:
**WO 2003/012858 (13.02.2003 Gazette 2003/07)**

(54) **METHOD OF THERMALLY RELEASING A CHIP FROM A THERMAL RELEASE TYPE PRESSURE SENSITIVE ADHESIVE SHEET**

VERFAHREN ZUR WÄRMEABLÖSUNG VON CHIP-AUSSCHNITTEN VON EINEM KLEBEBLATT DES WÄRMEABLÖSETYPS

PROCEDE DE SEPARATION PAR PELAGE THERMIQUE DE PIECES DECOUPEES EN COPEAUX A PARTIR D'UNE FEUILLE ADHESIVE DE TYPE A SEPARATION PAR PELAGE THERMIQUE

(84) Designated Contracting States:
**AT DE GB**

(30) Priority: **30.07.2001 JP 2001229591**

(43) Date of publication of application:
**16.06.2004 Bulletin 2004/25**

(73) Proprietor: **NITTO DENKO CORPORATION**
**Ibaraki-shi,**
**Osaka 567-8680 (JP)**

(72) Inventors:
• **MURATA, Akihisa,**
**c/o Nitto Denko Corporation**
**Ibaraki-shi,**
**Osaka 567-8680 (JP)**
• **OSHIMA, Toshiyuki,**
**c/o Nitto Denko Corporation**
**Ibaraki-shi,**
**Osaka 567-8680 (JP)**
• **ARIMITSU, Yukio,**
**c/o Nitto Denko Corporation**
**Ibaraki-shi,**
**Osaka 567-8680 (JP)**

• **KIUCHI, Kazuyuki,**
**c/o Nitto Denko Corporation**
**Ibaraki-shi,**
**Osaka 567-8680 (JP)**
• **SATO, Masaaki,**
**c/o Nitto Denko Corporation**
**Ibaraki-shi,**
**Osaka 567-8680 (JP)**
• **KAWANISHI, Michirou,**
**c/o Nitto Denko Corporation**
**Ibaraki-shi,**
**Osaka 567-8680 (JP)**

(74) Representative: **Grünecker, Kinkeldey,**
**Stockmair & Schwanhäusser**
**Anwaltssozietät**
**Leopoldstrasse 4**
**80802 München (DE)**

(56) References cited:
**JP-A- 6 151 585      JP-A- 7 045 645**
**JP-A- 11 001 671     JP-A- 59 130 438**
**JP-A- 2000 349 107**

EP 1 429 378 B1

**Description**

<Technical Field>

The present invention relates to a method for thermally releasing a chip cut piece from a thermal release type pressure sensitive adhesive sheet, and an electronic component or a circuit board constituted by chip cut pieces collected by this method.

<Background Art>

Sheets each having a support base material and a foaming agent-containing pressure sensitive adhesive layer provided on the support base material were heretofore known as adhesive sheets used in a method for holding a cut body of a semiconductor wafer, a quartz wafer or the like stuck onto the adhesive sheet through the pressure sensitive adhesive layer and for releasing and collecting cut pieces of chips (chip cut pieces) or the like formed by cutting the cut body into a predetermined size from the adhesive sheet (e.g., Examined Japanese Patent Publication No. Sho-50-13878, Examined Japanese Patent Publication No. Sho-51-24534, Unexamined Japanese Patent Publication No. Sho-56-61468, Unexamined Japanese Patent Publication No. Sho-56-61469, Unexamined Japanese Patent Publication No. Sho-60-252681, and so on). These aim at reduction of adhesive power by foaming or expansion due to heating of the foaming agent contained in the pressure sensitive adhesive layer, so as to successfully combine retention of adhesion sufficiently strong to endure the cut body cutting process with easy releasing and collection of the formed cut pieces. A hot air dryer, a hot plate, an air dryer, an infrared lamp, heated water or the like was generally used for thermally releasing the adherend from the thermal release type pressure sensitive adhesive sheet which was easy to release the adherend by heating in the aforementioned manner.

When the chip cut piece (semiconductor chip or the like) was to be thermally released and collected from the thermal release type pressure sensitive adhesive sheet while the position of the chip cut piece was recognized by an image recognition device or the like, there was however the possibility that failure in collection might be caused by failure in position recognition because regularity of the chip cut piece in the horizontal direction was spoiled to thereby result in position displacement of the chip cut piece due to the inf luence of thermal shrinkage of the base material of the thermal release type pressure sensitive adhesive sheet by heating. Particularly when a stretchable film was used as the base material (e.g., Unexamined Japanese Patent Publication No. Hei-11-001617, etc.), the problem was apt to occur. A known method of thermally releasing chips from a sheet is described in JP-A-2000349107.

<Disclosure Of The Invention>

Therefore, an object of the invention is to provide a method for thermally releasing a chip cut piece from a thermal release type pressure sensitive adhesive sheet, in which position displacement of the chip cut piece in the horizontal direction can be prevented when the chip cut piece stuck onto the thermal release type pressure sensitive adhesive sheet is thermally released from the thermal release type pressure sensitive adhesive sheet, and an electronic component and a circuit board constituted by chip cut pieces collected by the method.

The present inventors have made examination eagerly to achieve the foregoing object. As a result, it has been found that when the thermal release type pressure sensitive adhesive sheet is heated while restrained, deformation of the base material in the horizontal direction due to thermal shrinkage can be prevented extremely so that horizontal position displacement of the chip cut piece to be thermally released can be suppressed or prevented. Thus, the invention has been accomplished.

That is, a subject of the invention is a method of thermally releasing a chip cut piece from a thermal release type pressure sensitive adhesive sheet having a base material, and a thermally expandable microsphere-containing thermally expandable pressure sensitive adhesive layer provided on a surface of the base material according to claim 1.

In the invention, a means for restraining the thermal release type pressure sensitive adhesive sheet is an absorption means using suction.

<Brief Description of the Drawings>

Fig. 1 is a schematic sectional view showing an example of the thermal releasing method according to the invention;
Fig. 2 is a schematic sectional view showing another example of the thermal releasing method not forming part of the invention;
Fig. 3 is a schematic sectional view showing an example of the thermal release type pressure sensitive adhesive sheet used in the invention;

Fig. 4 is a schematic sectional view showing another example of the thermal release type pressure sensitive adhesive sheet used in the invention; and

Fig. 5 is a schematic view showing a hot plate with a built-in air absorption function.

Incidentally, in the drawings, the reference numeral 1 designates a restraining table; 11, a restraining table; 1a, a suction path of the restraining table 1; 11b, a restraining adhesive layer; 2, a thermal release type pressure sensitive adhesive sheet; 2a, a base material of the thermal release type pressure sensitive adhesive sheet 2; 2b, a thermally expandable pressure sensitive adhesive layer of the thermal release type pressure sensitive adhesive sheet 2; 2c, a separator; 2d, a rubber-like organic elastic layer; 3, a cut body; 3a, a chip cut piece; 3b, a cut region of the cut body 3; X, a horizontal direction; Y, a vertical direction: 4, a hot plate with a built-in air absorption function; 4a, a restraining area; and 4b, a heating stage.

<Best Mode for Carrying Out the Invention>

An embodiment of the invention will be described below in detail wi th reference to the drawings according to necessity. Incidentally, like parts and regions may be designated by like reference numerals.

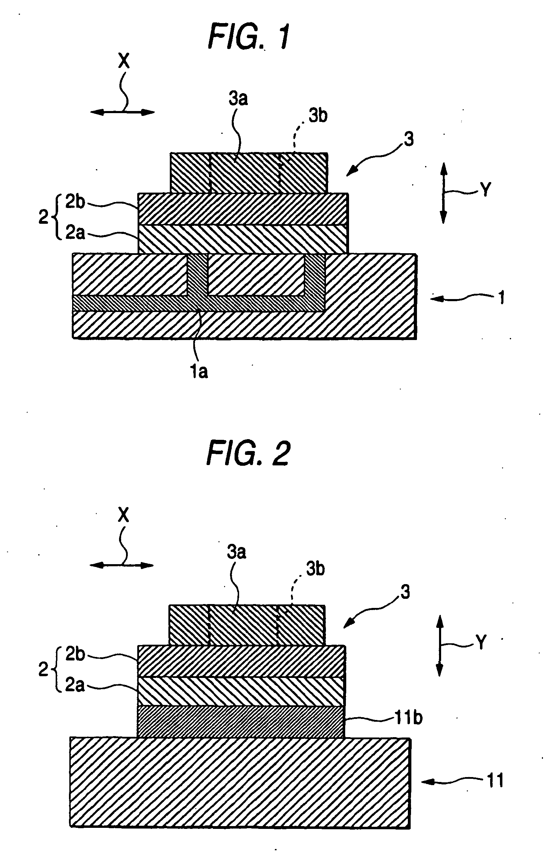

Fig. 1 is a schematic sectional view showing an example of a thermal releasing method according to the invention. In Fig. 1, the reference numeral 1 designates a restraining table; 1a, a suction path of the restraining table 1; 2, a thermal release type pressure sensitive adhesive sheet; 2a, a base material of the thermal release type pressure sensitive adhesive sheet 2; 2b, a thermally expandable pressure sensitive adhesive layer of the thermal release type pressure sensitive adhesive sheet 2; 3, a cut body; 3a, a chip cut piece; and 3b, a cut region of the cut body 3. Further, the sign X designates a horizontal direction (a direction parallel to an upper surface of the restraining table); and Y, a vertical direction (a direction perpendicular to the upper surface of the restraining table). In Fig. 1, the cut body 3 has been already cut into a specific shape at the cut region 3b, so that the cut body 3 has the chip cut piece 3a. The thermal release type pressure sensitive adhesive sheet 2 having the thermally expandable pressure sensitive adhesive layer 2b on which the cut body 3 is stuck is put on the restraining table 1 so that the base material 2a is disposed on the restraining table 1 side. The restraining table 1 has the suction path 1a in its inside. One side of the restraining path 1a is formed as open ends on the restraining table whereas the other side is connected to a suction machine (such as a suction pump or the like for sucking air). For this reason, the thermal release type pressure sensitive adhesive sheet 2 put on the restraining table 1 can be restrained when the suction machine is operated so that suction is performed through the suction path 1a.

Fig. 2 is a schematic sectional view showing an example of the thermal releasing method not forming part of the invention. In Fig. 2, the reference numeral 11 designates a restraining table; 11b, a restraining adhesive layer; 2, a thermal release type pressure sensitive adhesive sheet; 2a, a base material of the thermal release type pressure sensitive adhesive sheet 2; 2b, a thermally expandable pressure sensitive adhesive layer of the thermal release type pressure sensitive adhesive sheet 2; 3, a cut body; 3a, a chip cut piece; and 3b, a cut region of the cut body 3. Further, the sign X designates a horizontal direction (a direction parallel to an upper surface of the restraining table); and Y, a vertical direction (a direction perpendicular to the upper surface of the restraining table). In Fig. 2, the cut body 3 has been already cut into a specific shape at the cut region 3b, so that the cut body 3 has the ch ip cut piece 3a. The thermal release type pressure sensitive adhesive sheet 2 having the thermally expandable pressure sensitive adhesive layer 2b on which the cut body 3 is stuck is put on the restraining table 11 so that the base material 2a is disposed on the restraining table 11 side. The restraining table 11 has the restraining adhesive layer 11b provided thereon. The thermal release type pressure sensitive adhesive sheet 2 put on the restraining table 11 can be restrained when the thermal release type pressure sensitive adhesive sheet 2 is bondedonto the restraining table 11 through the restraining adhesive layer 11b.

In the illustration in the condition that the thermal release type pressure sensitive adhesive sheet 2 having the thermally expandable pressure sensitive adhesive layer 2b on which the cut body 3 is stuck is restrained in this manner, the thermal release type pressure sensitive adhesive sheet 2 (especially, the base material 2a of the thermal release type pressure sensitive adhesive sheet 2) is heated so that the chip cut piece 3a of the cut body 3 is released from the thermal release type pressure sensitive adhesive sheet 2. Accordingly, even in the case where the base material 2a of the thermal release type pressure sensitive adhesive sheet 2 is to be deformed in the horizontal direction X by expansion or the like due to heating, there is little or no position displacement of the thermal release type pressure sensitive adhesive sheet 2 in the horizontal direction X relative to the restraining table (1, 11) because a bottom of the base material 2a is restrained by the restraining table (1, 11) to suppress or prevent motion (such as de formation etc.) in the horizontal direction X. For this reason, even in the case where the position of the cut body 3 or the chip cut piece 3a stuck onto the thermally expandable pressure sensitive adhesive layer 2b of the thermal release type pressure sensitive adhesive sheet 2 is displaced in the vertical direction Y because of the expansion of the thermally expandable pressure sensitive adhesive layer 2b or the like, there is little or no position displacement of the cut body 3 or the chip cut piece 3a in the horizontal direction X.

Such a means for restraining the thermal release type pressure sensitive adhesive sheet is not particularly limited if the means can restrain the sheet (especially, restrain motion in the horizontal direction) and can suppress the deformation of the base material of the sheet. For example, an absorption means using suction (suction absorption means) as shown in Fig. 1 or a bonding means using an adhesive agent as shown in Fig. 2 can be illustrated. In the invention, an absorption means using suction of gas or a bonding means using an adhesive agent may be preferably used as the means for restraining the thermal release type pressure sensitive adhesive sheet. Incidentally, in the restraining means, the base material (especially, motion in the horizontal direction) of the thermal release type pressure sensitive adhesive sheet can be restrained. A single restraining means may be used as the restraining means or two or more restraining means may be used in combination.

In the case where an absorption means using suction is used as the restraining means, for example, the restraining table may be provided with a means by which the thermal release type pressure sensitive adhesive sheet (especially, the base material abutting on the restraining table) put on the restraining table can be absorbed and restrained onto the restraining table by suction of gas. The restraining table having such an absorption means is not particularly limited but the restraining table 1 having the suction path 1a as shown in Fig. 1 can be shown as an example. In the restraining table having the suction path, the size and length of the suction path, the shape (e.g., a circular shape, a polygonal shape, or the like) of each open end on the restraining table, and so on, are not particularly limited. The suction machine is not particularly limited. In the invention, the restraining table having the suction path may have any structure if the internal pressure of the suction path can be reduced by suction of gas to thereby restrain the thermal release type pressure sensitive adhesive sheet (especially, the base material of the thermal release type pressure sensitive adhesive sheet) put on the restraining table.

In the case where a bonding means using an adhesive agent is used as the restraining means, for example, the restraining table or the thermal release type pressure sensitive adhesive sheet may be provided with a means by which the thermal release type pressure sensitive adhesive sheet (especially, the base material abutting on the restraining table) put on the restraining table can be bonded and restrained onto the restraining table by an adhesive agent. The bonding means is not particularly limited but, for example, the restraining adhesive layer may be provided between the restraining table and the thermal release type pressure sensitive adhesive sheet. More specifically, the restraining adhesive layer may be provided on the restraining table 11 as shown in Fig. 2 or may be provided on a surface of the base material 2a of the thermal release type pressure sensitive adhesive sheet 2. In the case of provision of the restraining adhesive layer on a surface of the base material 2a of the thermal release type pressure sensitive adhesive sheet 2, the restraining adhesive layer may be provided on one surface of the base material in advance (i.e., the thermal release type pressure sensitive adhesive sheet may be formed as a double-sided pressure sensitive adhesive sheet in which the thermally expandable pressure sensitive adhesive layer is provided on one surface of the base material while the restraining adhesive layer is provided on the other surface of the base material) or an adhesive agent for forming the restraining adhesive layer may be applied onto an open surface of the base material at the time of putting the thermal release type pressure sensitive adhesive sheet 2 on the restraining table to thereby provide the restraining adhesive layer on the base material.

The restraining adhesive layer can be made of a heat-resistant adhesive agent (such as a thermosetting adhesive agent, an ultraviolet-setting adhesive agent, or the like), a heat-resistant pressure sensitive adhesive agent, or the like, having heat resistance to a temperature of not lower than the thermal release temperature of the thermally expandable pressure sensitive adhesive layer 2b of the thermal release type pressure sensitive adhesive sheet 2, and high-temperature adhesion sufficient to avoid floating, peeling or the like from the restraining table even at the thermal release temperature. With respect to the heat-resistant adhesive agent, a commonly used or known thermosetting adhesive agent (e.g., an epoxy adhesive agent, an urethane adhesive agent, etc.) or ultraviolet-setting adhesive agent (e.g., an energy beam-setting acrylic pressure sensitive adhesive agent, etc.) may be used as the thermosetting adhesive agent or ultraviolet-setting adhesive agent. With respect to the heat-resistant pressure sensitive adhesive agent, a pressure sensitive adhesive agent containing a heat-resistant resin such as a thermosetting resin (e.g., an epoxy resin, an unsaturated polyester resin, a thermosetting acrylic resin, a phenol resin, etc.), an ultraviolet-setting resin, or the like, may be used.

The restraining adhesive layer may have a thermal releasing function having a release temperature higher than the thermal release temperature of the thermally expandable pressure sensitive adhesive layer 2b. When the restraining adhesive layer has a thermal releasing function in this manner, for example, the thermal release type pressure sensitive adhesive sheet may be a double-sided thermal release type pressure sensitive adhesive sheet on which thermally expandable pressure sensitive adhesive layers different in release temperature are provided on opposite surfaces of the base material respectively.

The thickness of the restraining adhesive layer is not particularly limited but, for example, may be selected to be in a range of from 1 to 100 $\mu$m, preferably in a range of from 5 to 50 $\mu$m.

The restraining adhesive layer can be formed by a commonly used method such as a method in which a coating solution containing an adhesive component such as a heat-resistant adhesive agent, a heat-resistant pressure sensitive adhesive agent, or the like, and containing an additive, a solvent, etc. according to necessity is applied on the restraining table or on the base material of the thermal release type pressure sensitive adhesive sheet; a method in which a restraining adhesive layer formed by application of the coating solution on an appropriate separator (such as release paper or the like) is transferred (shifted) onto the restraining table or onto the base material of the thermal release type pressure sensitive adhesive sheet; or the like.

Incidentally, the thermal releasing method for releasing the chip cut piece 3a from the thermal release type pressure sensitive adhesive sheet 2 is not particularly limited but a commonly used or known thermal releasing method may be used. With respect to a heating source, for example, a heating source such as a hot plate or the like may be incorporated in the restraining table (1, 11) per se so that the restraining table serves as a heating source or a heating source may be provided separately from the restraining table. A hot air dryer, an infrared lamp, a hot plate, an air dryer, etc. or devices using these may be generally used as the heating source but the heating source is not limited thereto. The heating temperature may be selected to be not lower than the foaming start temperature of thermally expandable microspheres contained in the thermally expandable pressure sensitive adhesive layer 2b.

[Restraining Table]

The restraining table (1, 11) can be made of a material having heat resistance to a temperature of not lower than the thermal release temperature of the thermal release type pressure sensitive adhesive sheet 2. Examples of the material for forming the restraining table (1, 11) include: metals such as stainless steel, iron, etc. or their alloys; heat-resistant plastics; and so on. With respect to the material for forming the restraining table (1, 11), a single material may be used or two or more kinds of materials may be used in combination. The restraining table (1, 11) may have a single layer structure or may have a multi-layer structure.

The shape of the restraining table (1, 11) can be selected suitably in accordance with the shape of the cut body, the device for cutting the cut body, and so on.

[Thermal Release Type Pressure Sensitive Adhesive Sheet]

A commonly used or known thermal release type pressure sensitive adhesive sheet (e.g., described in Examined Japanese Patent Publication No. Sho-50-13878, Examined Japanese Patent Publication No. Sho-51-24534, Unexamined Japanese Patent Publication No. Sho-56-61468, Unexamined Japanese Patent Publication No. Sho-56-61469, Unexamined Japanese Patent Publication No. Sho-60-252681, etc.) can be used as the thermal release type pressure sensitive adhesive sheet 2. For example, a thermal release type pressure sensitive adhesive sheet such as trade name "REVALPHA" (Made by Nitto Denko Corporation) or the like is commercially available.

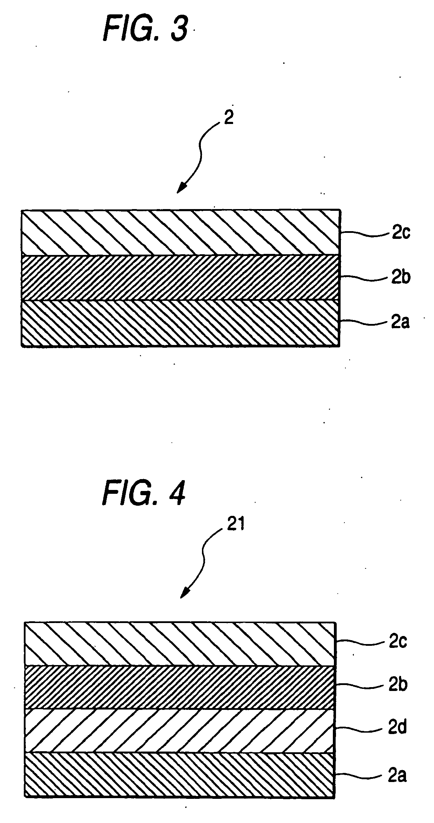

For example, a thermal release type pressure sensitive adhesive sheet having a layer structure as shown in Fig. 3 may be used as the thermal release type pressure sensitive adhesive sheet. Fig. 3 is a schematic sectional view showing an example of the thermal release type pressure sensitive adhesive sheet used in the invention. In Fig. 3, the reference numeral 2 designates a thermal release type pressure sensitive adhesive sheet; 2a, a base material; 2b, a thermally expandable pressure sensitive adhesive; and 2c, a separator.

More specifically, a material having appropriate heat resistance sufficient to prevent mechanical material property from being spoiled by heat treatment may be preferably used as the base material 2a of the thermal release type pressure sensitive adhesive sheet 2. Examples of the material include a hard or soft plastic film, paper, nonwoven fabric, metal foil, etc.

On the other hand, the thermally expandable pressure sensitive adhesive layer 2b provided on a surface of the base material 2a can be made of a thermally expandable microsphere-containing viscoelastic composition in which thermally expandable microspheres for giving thermally expanding characteristic are mixed with a viscoelastic substance. A substance having appropriate viscoelastic properties to allow foaming and/or expansion of the thermally expandable microspheres at the time of heating can be used as the viscoelastic substance. Example of the viscoelastic substance include: rubber such as natural rubber, synthetic rubber, silicone rubber, or the like; a resin such as a polyurethane resin, an ethylene-vinyl acetate copolymer, a copolymer resin of acrylic ester and its derivatives, or the like; a pressure sensitive adhesive agent (e.g., a pressure sensitive adhesive agent such as an acrylic pressure sensitive adhesive agent or the like) using the rubber or resin as a base polymer; and so on.

Micro spheres (microcapsules) in each of which a substance (e.g., isobutane, propane, pentane, etc.) easily vaporized to expand by heating is included in a shell having elasticity can be used as the thermally expandable microspheres. Examples of a substance for forming the shell include vinylidene chloride-acrylonitrile copolymer, polyvinyl alcohol, polyvinylbutyral, polymethylmethacrylate, polyacrylonitrile, polyvinylidene chloride, polysulfone, etc. The thermally expandable microspheres can be formed by a commonly used method such as a coacervation method, an interfacial polymerization method, an in-situ polymerization method, or the like. For example, commercially available articles, such as series of trade name "MATSUMOTO MICROSPHERE" made by Matsumoto Yushi-Seiyaku Co., Ltd., etc., may be used as the thermally expandable microspheres.

Incidentally, in the thermal release type pressure sensitive adhesive sheet 2, another layer (e.g., a rubber-like organic elastic layer or the like), for example, as shown in Fig. 4 may be interposed between the base material 2a and the thermally expandable pressure sensitive adhesive layer 2b as occasion demands. Fig. 4 is a schematic sectional view showing another example of the thermal release type pressure sensitive adhesive sheet used in the invention. In Fig. 4, the reference numeral 21 designates a thermal release type pressure sensitive adhesive sheet; 2a, a base material; 2b, a thermally expandable pressure sensitive adhesive layer; 2c, a separator; and 2d, a rubber-like organic elastic layer.

It is a matter of course that the thermal release type pressure sensitive adhesive sheet shown in each of Figs. 3 and 4 can be used after the separator 2c for protecting the thermally expandable pressure sensitive adhesive layer 2b is peeled off.

The thermal release type pressure sensitive adhesive sheet 2 can be formed by a commonly used method such as a method in which a coating solution (thermally expandable microsphere-containing viscoelastic composition) containing thermally expandable microspheres and a viscoelastic substance and containing an additive, a solvent, etc. according to necessity is applied on the base material 2a; a method in which a thermally expandable pressure sensitive adhesive layer 2b formed by application of the coating solution on an appropriate separator (such as release paper or the like) is transferred (shifted) onto the base material 2a; or the like.

In the thermal release type pressure sensitive adhesive sheet 2, the thickness of the base material 2a is selected to be generally not larger than 500 $\mu$m (e.g., from 1 to 500 $\mu$m), preferably in a range of from 3 to 300 $\mu$m, especially in a range of from about 10 to 250 $\mu$m. The thickness of the thermally expandable pressure sensitive adhesive layer 2b may be selected to be, for example, not larger than 300 $\mu$m (e.g., from 1 to 300 $\mu$m), preferably not larger than 200 $\mu$m (e.g., from 5 to 200 $\mu$m).

Incidentally, the thermal release type pressure sensitive adhesive sheet 2 may has any suitable shape such as a sheet shape, a tape shape, or the like.

[Chip Cut Piece]

In the invention, the chip cut piece 3a is not particularly limited if the process of releasing the chip cut piece 3a from the pressure sensitive adhesive sheet can be performed after the process of cutting the cut body stuck onto the pressure sensitive adhesive sheet. Incidentally, an apparatus for thermally releasing the chip cut piece and collecting the chip cut piece while recognizing the position of the chip cut piece is generally industrially used in the releasing process. In the invention, because there is no position displacement in the horizontal method when the chip cut piece 3a is thermally released, failure in position recognition by the collecting apparatus can be prevented. Accordingly, when the thermal releasing method according to the invention is used for collecting the chip cut piece 3a, the rate of collection of the chip cut piece 3a can be improved greatly.

More specifically, examples of the chip cut piece 3a include chip type electronic components, circuit boards, etc. For example, the electronic components and circuit boards as examples of the chip cut piece 3a are semiconductor chips, laminated ceramic capacitors, chip type quartz oscillators, etc.

The cut body 3 stuck onto the thermal release type pressure sensitive adhesive sheet 2 is cut in the form of a chip to thereby produce the chip cut piece 3a. The cutting method is not particularly limited but a commonly used or known cutting method may be used. Incidentally, with respect to the chip cut piece 3a, one piece may be stuck onto one thermal release type pressure sensitive adhesive sheet 2 or a plurality of pieces may be stuck onto one thermal release type pressure sensitive adhesive sheet 2.

<Examples>

The invention will be described below in more detail on the basis of Examples but the invention is not limited to the Examples at all.

(Example 1 not forming part of the invention)

A 100 $\mu$m-thick quartz substrate was stuck to a thermal release type pressure sensitive adhesive layer of a thermal release type pressure sensitive adhesive sheet [trade name "REVALPHA No. 3195MS: 120°C thermal release type" made by Nitto Denko Corporation and having a base material of polyethylene terephthalate (PET base material)]. A glass-epoxy dicer ring was further stuck. Then, the base material side of the thermal release type pressure sensitive adhesive sheet was stuck onto a restraining plate (10 mm thick) of stainless steel (SUS304) by a one-component epoxy adhesive agent [trade name "TECHNODYNE AH6041W" made by Taoka Chemical Co. , Ltd.] (the curing condition of the adhesive agent: 80°C X 60 minutes).

Then, after dicing into 5 mm-square chips was performed by a dicer (DFD-651 made by Disco Corporation), a thermal release process was performed in a hot air dryer (temperature chamber SPH-201 made by Espec Corp.) in the condition of 130°C X 10 minutes.

Incidentally, the term "glass-epoxy" means a glass base copper-clad laminate as a kind of circuit board material having a sheet of copper foil piled on each or either of opposite surfaces of a laminate of a predetermined pieces of glass cloth each containing an epoxy resin impregnated therein and cured.

(Example 2 illustrating the invention)

Into 100 parts by weight of a pressure sensitive adhesive agent (containing 2 parts by weight of a polyurethane crosslinker) made of a 2-ethylhexyl acrylate-ethyl acrylate-methyl methacrylate (50 parts by weight/50 parts by weight/ 5 parts by weight) terpolymer, 30 parts by weight of thermally expandable microspheres (trade name "MATSUMOTO MICROSPHERE F-50D" made by Matsumoto Yushi-Seiyaku Co., Ltd.) were added to prepare a toluene solution.

The toluene solution was applied on a silicone-treated releasable polyester film (trade name "#SERAPIRU" made by Toyo Metalizing Co., Ltd., 38 $\mu$m thick) so that the thickness of the toluene solution after drying was 30 $\mu$m. After the toluene solution was dried, the silicone-treated releasable polyester film was stuck onto a 70 $\mu$m-thick poly-propylene/polyethylene blended film (trade name "FBS" made by Futamura Chemical Industries Co., Ltd.) so that the dried toluene solution was transferred onto the polypropylene/polyethylene blended film. Thus, a thermal release type pressure sensitive adhesive sheet was produced. (Incidentally, in the thermal release type pressure sensitive adhesive sheet, the silicone-treated releasable polyester film was used as a separator.)

The separator was peeled off from the produced thermal release type pressure sensitive adhesive sheet. A 400 $\mu$m-thick silicon wafer (made by Shin-Etsu Handotai Co., Ltd.) was stuck to the thermally expandable pressure sensitive adhesive layer. A dicer ring of stainless steel (SUS304) was further stuck.

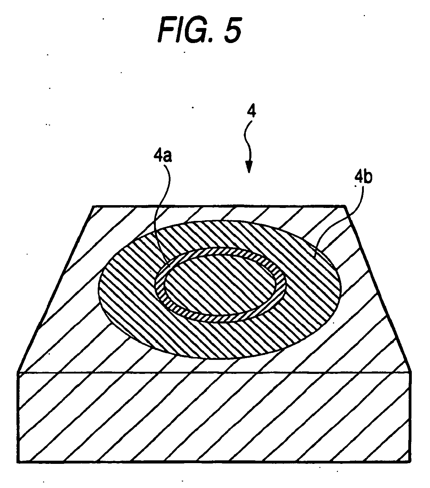

Then, after dicing into 5 mm-square chips was performed by a dicer (DFD-651 made by Disco Corporation) , a thermal release process was performed in the condition that the chips were heated from room temperature to 130°C while restrained on an air absorption function-including hot plate (see Fig. 5).

Fig. 5 is a schematic view showing the air absorption function-including hot plate. In Fig. 5, the reference numeral 4 designates an air absorption function-including hot plate; 4a, a restraining area; and 4b, a heating stage. The air absorption function-including hot plate 4 raises the temperature of the heating stage 4b so that the matter put on the hot plate 4 can be heated. The restraining area 4a serves as a suction path la shown in Fig. 1. The restraining area 4a is connected to a suction machine, so that the matter put on the hot plate 4 can be restrained by suction of gas.

(Comparative Example 1)

A quartz substrate stuck onto the thermal release type pressure sensitive adhesive sheet was thermally released in the same manner as in Example 1 except that the one-component epoxy adhesive agent and the restraining plate of stainless steel (SUS304) were not used.

(Comparative Example 2)

A silicon wafer stuck onto the thermal release type pressure sensitive adhesive sheet was thermally released in the same manner as in Example 2 except that the air absorption function-including hot plate 4 was replaced by a general hot plate (a hot plate having no air absorption function).

(Evaluation)

The recovery success rate was measured in the case where chips after the thermal release process in each of Examples 1 and 2 and Comparative Examples 1 and 2 were arranged automatically in a recovery tray by an image recognition air pick-up device. Results of the measurement were as shown in Table 1. Incidentally, the recovery success rate was obtained by the following calculation equation.

`Recovery Success Rate (%) = {(Number of Arranged and`

Collected Chips) / (Total Number of Chips)} X 100

TABLE 1

|  | Recovery Success Rate (%) |
|---|---|
| Example 1 | 100 |
| Example 2 (invention) | 100 |
| Comparative Example 1 | 35 |
| Comparative Example 2 | 0 |

FromTable 1, the recovery success rate in each of Examples 1 and 2 was 100 %. Examples 1 and 2 are very excellent in position recognizability of the image recognition air pick-up device. Accordingly, failure in position recognition can be prevented.

On the other hand, the recovery success rate in Comparative Example 1 was low to be 35 % and the recovery success rate in Comparative Example 2 was 0 %. Incidentally, in Comparative Example 1, the warp of the glass-epoxy dicer ring was observed because of the influence of thermal shrinkage of the PET base material. In Comparative Example 2, wide surface waviness caused by thermal shrinkage of the base material was observed.

<Industrial Applicability>

In the method of thermally releasing the chip cut piece from the thermal release type pressure sensitive adhesive sheet according to the invention, the thermal release type pressure sensitive adhesive sheet is heated while restrained. Accordingly, deformation of the base material in the horizontal direction due to thermal shrinkage is prevented and the position of the chip cut piece to be thermally released is therefore prevented from being displaced in the horizontal direction. Accordingly, failure in position recognition by the collecting device can be prevented when the chip cut piece is thermally released to be collected.

**Claims**

1.   A method of thermally releasing a chip (3a) from a thermal release type pressure sensitive adhesive sheet (2) having a base material(2a), and a thermally expandable microsphere-containing thermally expandable pressure sensitive adhesive layer (2b) provided on a surface of the base material(2a), including the step of heating said thermal release type pressure sensitive adhesive sheet (2) while restraining a bottom of the base material (2a) by a restraining table (1,11) in a direction parallel to the upper surface of the restraining table (1,11) by suction thereby releasing the chip stuck on thermal release type pressure sensitive adhesive sheet from said thermal release type pressure sensitive adhesive sheet (2), **characterized in that**
the restraining table (1,11) has an absorption means using suction for restraining said thermal release type pressure sensitive adhesive sheet (2).

**Patentansprüche**

1.   Verfahren zum thermischen Lösen eines Chips (3a) von einer thermisch lösbaren druckempfindlichen Klebefolie (2), die ein Trägermaterial (2a) und eine Schicht (2b) aus wärmeexpandierbarem druckempfindlichen Klebstoff aufweist, die wärmeexpandierbare Mikrokugeln enthält und an einer Oberfläche des Trägermaterials (2a) vorhanden ist, wobei das Verfahren den Schritt einschließt, in dem die wärmelösbare druckempfindliche Klebstofffolie (2) erhitzt wird und dabei gleichzeitig eine Unterseite des Trägermaterials (2a) mittels eines Haltetischs (1, 11) in einer Richtung parallel zu der oberen Fläche des Haltetischs (1, 11) mittels Sog gehalten wird, um so den an der wärmelösbaren druckempfindlichen Klebstofffolie haftenden Chip von der wärmelösbaren druckempfindlichen Klebstofffolie (2) zu lösen, **dadurch gekennzeichnet, dass**
der Haltetisch (1, 11) eine Absorptionseinrichtung aufweist, die Sog nutzt, um die wärmelösbare druckempfindliche Klebstofffolie (2) zu halten.

**Revendications**

1. Procédé de séparation par pelage thermique d'une pièce découpée en copeaux (3a) d'une feuille adhésive sensible à la pression de type à séparation par pelage thermique (2) ayant un matériau de base (2a) et une couche adhésive sensible à la pression thermiquement expansible (2b) contenant des microsphères thermiquement expansibles prévue sur une surface du matériau de base (2a), comprenant l'étape consistant à faire chauffer ladite feuille adhésive sensible à la pression de type à séparation par pelage thermique (2) tout en retenant un fond du matériau de base (2a) par une table de retenue (1, 11) dans une direction parallèle à la surface supérieure de la table de retenue (1, 11), par aspiration, séparant ainsi la pièce découpée en copeaux collée sur ladite feuille adhésive sensible à la pression de type à séparation par pelage thermique de ladite feuille adhésive sensible à la pression de type à séparation par pelage thermique (2), **caractérisé en ce que** :

   la table de retenue (1, 11) a des moyens d'absorption utilisant l'aspiration pour retenir ladite feuille adhésive sensible à la pression de type à séparation par pelage thermique (2).

## FIG. 1

X

3a
3b
3

2 { 2b
2a

Y

1

1a

## FIG. 2

X

3a
3b
3

2 { 2b
2a

Y

11b

11

## FIG. 3

2

2c
2b
2a

## FIG. 4

21

2c
2b
2d
2a

# FIG. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP SHO5013878 B
- JP SHO5124534 B
- JP SHO5661468 B
- JP SHO5661469 B

- JP SHO60252681 B
- JP HEI11001617 B
- JP 2000349107 A

**Non-patent literature cited in the description**

- MATSUMOTO MICROSPHERE. Matsumoto Yushi-Seiyaku Co., Ltd,